(19) Europäisches Patentamt
European Patent Office
Office européen des brevets

(11) **EP 1 804 379 A1**

(12) **DEMANDE DE BREVET EUROPEEN**

(43) Date de publication:
**04.07.2007 Bulletin 2007/27**

(21) Numéro de dépôt: **06292023.6**

(22) Date de dépôt: **22.12.2006**

(51) Int Cl.:
*H03H 11/04* (2006.01)   *H03H 11/12* (2006.01)
*H03F 3/19* (2006.01)   *H03F 3/21* (2006.01)
*H03F 3/60* (2006.01)   *H03F 1/32* (2006.01)

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **30.12.2005 FR 0513489**

(71) Demandeurs:
• **STMicroelectronics SA**
  **92120 Montrouge (FR)**
• **Centre National de la Recherche Scientifique**
  **75016 Paris (FR)**

(72) Inventeurs:
• **Chamla, David**
  **38000 Grenoble (FR)**
• **Cathelin, Andreia**
  **38190 Laval (FR)**
• **Kaiser, Andreas**
  **59650 Villeneuve d'Ascq (FR)**

(74) Mandataire: **Zapalowicz, Francis**
  **Bureau D.A. Casalonga & Josse**
  **Bayerstrasse 71/73**
  **80335 München (DE)**

(54) **Procédé de contrôle du rapport des facteurs d'amplification de deux amplificateurs linéaires, et dispositif correspondant**

(57)    L'invention porte sur un dispositif électronique, qui comprend un circuit principal comportant :
deux amplificateurs linéaires principaux (AP1, AP2) ayant des facteurs d'amplification respectivement commandables (gm 1, gm2) par deux signaux de commande principaux (Vcde1, Vcde2), aptes à recevoir respectivement deux signaux d'entrée et à délivrer deux signaux de sortie, les niveaux des deux signaux d'entrée étant dans un rapport N, et
des moyens de contrôle (MC) aptes à ajuster la valeur d'au moins l'un des deux signaux de commande principaux de façon à égaliser les signaux de sortie, les deux facteurs d'amplification étant alors dans le même rapport N.

## FIG.1

## Description

L'invention concerne les amplificateurs, et notamment le contrôle du rapport entre les facteurs d'amplification d'au moins deux amplificateurs à facteur d'amplification commandable, en particulier pour les amplificateurs linéaires.

L'invention est avantageusement mais non limitativement utilisée dans le cadre des systèmes de télécommunication notamment au sein des chaînes de réception et en particulier pour le contrôle des fréquences de coupure de filtres incorporant des amplificateurs linéaires commandables, utilisés au sein des chaînes de réception.

Classiquement, une chaîne de réception comprend différents filtres dont la fréquence de coupure doit être fixée très précisément. Cependant, en raison des variations de température ou encore des variations de la tension d'alimentation par exemple, les paramètres des filtres utilisés présentent une variation très importante, d'environ 40 à 50 %.

De façon à limiter ces variations, la fréquence de coupure du filtre est contrôlée par un signal de contrôle délivré par un autre système appelé système maître. Cette structure est décrite par exemple dans l'article « Integrated Continuous-Time Filter Design - An Overview », Yannis Tsividis, IEEE Journal of Solid-State Circuits, vol.29, no. 3, Mar. 1997, pp. 166-176.

Dans ce cas, le système maître peut comprendre par exemple une boucle à verrouillage de phase fonctionnant selon une fréquence de référence stable délivrée par un composant externe, par exemple un oscillateur à quartz. Le système maître comporte des amplificateurs linéaires identiques (ou éventuellement homotétiques) à ceux incorporés dans le filtre, et avec un facteur d'amplification commandé en interne par le même signal utilisé pour contrôler la fr. équence de coupure du filtre.

Ce contrôle du type maître/esclave (l'esclave étant le filtre dans ce cas) peut permettre d'obtenir une précision de l'ordre de 5%.

Par ailleurs, de façon à pouvoir faire fonctionner le filtre dans différentes plages de fréquences, un diviseur ou un multiplieur par N peut être utilisé entre le signal de contrôle issu du système maître et le signal de commande du filtre, si le lien entre le facteur d'amplification des amplificateurs incorporés eu sein du filtre est sa grandeur de commande est parfaitement proportionnel. Ainsi on peut introduire le rapport N entre le facteur d'amplification des amplificateurs du système maître et le facteur d'amplification des amplificateurs du filtre.

Du fait de la relation entre le facteur d'amplification et la fréquence (détaillée ci-dessous), on fait varier la fréquence de coupure de ce dernier en fonction de la fréquence d'oscillation du système maître, dans le même rapport N.

En effet, si V désigne le signal de contrôle issu du système maître, et k le facteur d'amplification des amplificateurs parfaits utilisés dans le filtre et le système maître, et du fait de la relation k=A*V, A étant le coefficient reliant le signal de commande, il vient :

$$ f_{osc} \ = \ \frac{A \cdot V \cdot k}{2 \pi C} \ \text{ et } \ f_c = \frac{A \cdot V \cdot k}{N \cdot 2 \pi C} $$

avec $f_{osc}$ la fréquence d'oscillation du système maître, $f_c$ la fréquence de coupure du filtre, et C une valeur de capacité de référence du dispositif considéré (système maître ou filtre à contrôler).

D'où :

$$ f_c = f_{osc} / N \, . $$

Autrement dit, en commandant et en ajustant le facteur d'amplification k des amplificateurs incorporés dans le filtre à l'aide d'un signal de contrôle tel que décrit ci-dessus, on établit un rapport de N entre les facteurs d'amplification du système maître et du filtre et donc la fréquence d'oscillation du système maître, et la fréquence de coupure du filtre.

Cependant, le lien de proportionnalité entre la valeur du signal de contrôle de l'amplificateur et son facteur d'amplification propre n'est jamais parfait : des non-linéarités dans le contrôle de l'amplificateur existent toujours et mènent alors à l'impossibilité d'utiliser directement le principe énoncé ci-dessus entre le lien de proportionnalité théorique et celui constaté entre la fréquence d'oscillation du système maître et la fréquence de coupure du filtre, dans cet exemple.

L'invention vise à apporter une solution à ce problème.

Un but de l'invention est de proposer un dispositif apte à établir un rapport N entre au moins deux facteurs d'amplification, et par conséquent deux fréquences, indépendant des phénomènes de non-linéarité dans le contrôle des amplificateurs.

Un autre but de l'invention est de proposer un dispositif permettant de contrôler une fréquence de coupure de filtre à l'aide d'un signal stable externe, en particulier lorsqu'un rapport de division ou de multiplication est introduit entre la fréquence de coupure du filtre et la fréquence externe.

A cet effet, selon un premier aspect de l'invention, il est proposé un dispositif électronique, comprenant un circuit principal qui comporte :

deux amplificateurs linéaires principaux ayant des facteurs d'amplification respectivement commandables par deux signaux de commande principaux, aptes à recevoir respectivement deux signaux d'entrée et à délivrer deux signaux de sortie, les niveaux des deux signaux d'entrée étant dans un rapport N, et

des moyens de contrôle aptes à ajuster la valeur d'au moins l'un des deux signaux de commande principaux de façon à égaliser les signaux de sortie, les deux facteurs d'amplification étant alors dans le même rapport N.

En d'autres termes, on ajuste le rapport entre deux facteurs d'amplification de deux amplificateurs dit principaux, à l'aide de moyens de contrôle qui cherchent constamment à égaliser les signaux de sortie des deux amplificateurs principaux en adaptant l'un des signaux de commande.

Contrairement aux solutions existantes on agit donc sur les signaux de sortie pour ajuster les signaux de commande.

Du fait que les signaux d'entrée sont dans un rapport N, on obtient ce même rapport entre les facteurs d'amplification des deux amplificateurs principaux.

Les deux signaux de commande principaux, utilisés pour commander les amplificateurs principaux peuvent être employés pour commander n'importe quel autre facteur d'amplification d'au moins deux autres amplificateurs ou groupes d'amplificateurs, respectivement de même type et de même structure que les amplificateurs principaux, de façon à établir un rapport N entre ces autres facteurs d'amplification.

Dans une telle application, le circuit principal forme un coeur de régulation du rapport N, qui va permettre d'instaurer et de réguler un rapport N entre les facteurs d'amplifications d'autres amplificateurs.

Ainsi, contrairement aux solutions existantes qui utilisait deux signaux de commande liés par un facteur de proportionnalité, l'invention découple ces deux signaux de commande, et ajuste le rapport entre deux facteurs d'amplification à l'aide d'un autre circuit (le coeur de régulation) qui régule ce rapport à l'aide d'un moyen de contrôle agissant sur deux autres grandeurs, en l'occurrence les signaux de sortie des amplificateurs principaux.

Le terme « facteur d'amplification » englobe ici notamment les gains tension/tension, courant/courant, les transimpédances et les transconductances. Par conséquent, l'invention peut s'appliquer à tout type d'amplificateurs linéaires mettant en oeuvre l'un des facteurs d'amplification précités et les grandeurs électriques associées.

Selon un mode de réalisation, le circuit comporte en outre un générateur apte à générer un signal de référence, un diviseur ou un multiplieur par N couplé à la sortie du générateur et apte à délivrer ledit signal de référence divisé ou multiplié par N, le signal d'entrée de l'un des amplificateurs étant le signal de référence et le signal d'entrée de l'autre amplificateur étant le signal de référence divisé ou multiplié par N.

Selon un mode de réalisation, les moyens de contrôle comprennent des moyens d'asservissement aptes à asservir la valeur de l'un des signaux de commande à l'écart entre les deux signaux de sortie.

Les moyens d'asservissement peuvent comporter par exemple des moyens d'élaboration aptes à élaborer un signal intermédiaire représentatif de la différence entre les deux signaux de sortie, et un bloc de correction couplé aux moyens d'élaboration, apte à effectuer une correction de type proportionnelle-intégrale sur ledit signal intermédiaire.

Par ailleurs, le bloc de correction peut effectuer en outre une correction de type dérivée.

Selon un mode de réalisation, le circuit principal peut présenter une architecture différentielle, les signaux d'entrée et de sortie étant des grandeurs différentielles.

Dans le cas d'une architecture différentielle, les signaux de sortie délivrés par les amplificateurs principaux peuvent être des courants et les moyens d'élaboration peuvent comprendre des moyens d'addition aptes à additionner d'une part la valeur du courant délivré sur la première voie différentielle d'un premier amplificateur principal et la valeur du courant délivré sur la deuxième voie différentielle de l'autre amplificateur principal et d'autre part la valeur du courant délivré sur la deuxième voie différentielle dudit premier amplificateur principal et la valeur du courant délivré sur la première voie différentielle de l'autre amplificateur principal.

Le bloc de correction peut comprendre par exemple un amplificateur opérationnel, deux résistances, connectées entre chacune des entrées de l'amplificateur opérationnel et un générateur de tension de mode commun, un premier condensateur connecté entre l'entrée non-inverseuse de l'amplificateur opérationnel et la masse et un deuxième condensateur de même valeur que ledit premier condensateur, connecté entre la sortie et l'entrée inverseuse de l'amplificateur opérationnel.

Selon un mode de réalisation, le dispositif peut comprendre en outre au moins deux circuits auxiliaires comportant chacun au moins un amplificateur linéaire auxiliaire à facteur d'amplification commandable par un signal de commande auxiliaire, les amplificateurs auxiliaires des deux circuits auxiliaires ayant respectivement les mêmes structures que celles des deux amplificateurs principaux, et

dans lequel les signaux de commande auxiliaires respectivement associés aux deux circuits auxiliaires sont respectivement issus des signaux de commande principaux respectivement associés aux amplificateurs principaux de structures correspondantes.

En d'autres termes les signaux de commande auxiliaires sont chacun réalisés à partir des signaux de commande principaux découplés. Par conséquent, les signaux de commande auxiliaires sont eux même découplés ce qui a pour avantage de pouvoir utiliser des circuits auxiliaires avec des amplificateurs linéaires ayant des structures différentes.

Par exemple, le premier et le deuxième circuit auxiliaires peuvent comprendre respectivement un premier et un deuxième amplificateurs linéaires auxiliaires connectés en série, la sortie du deuxième amplificateur linéaire auxiliaire étant rebouclé sur son entrée.

Dans un autre exemple, un premier circuit auxiliaire forme des moyens esclaves, qui comportent des moyens de filtrage incorporant au moins un amplificateurs linéaires auxiliaires, et dans lequel

un deuxième circuit auxiliaire forme des moyens maîtres, aptes à asservir la fréquence de coupure des moyens de filtrage, et qui comportent une boucle à verrouillage de phase comprenant un oscillateur contrôlé en tension réalisé à l'aide d'au moins deux amplificateurs linéaires commandés par le signal de commande auxiliaire associé audit deuxième circuit auxiliaire,

le signal de commande auxiliaire associé audit deuxième circuit auxiliaire étant délivré au circuit principal de façon à réaliser le signal de commande de l'amplificateur principal recevant le signal de référence divisé ou multiplié par N.

Selon un autre aspect de l'invention, il est proposé un procédé de contrôle du rapport de facteurs d'amplification d'amplificateurs linéaires commandables, comprenant un ajustement à une valeur N désirée, du rapport entre les facteurs d'amplification respectifs de deux amplificateurs linéaires principaux commandables par deux signaux de commandes principaux, ledit ajustement comprenant

la réception de deux signaux d'entrée et la délivrance de deux signaux de sortie par les amplificateurs principaux, les niveaux des deux signaux d'entrée étant dans un rapport N, et

le contrôle de l'un des deux signaux de commande principaux de façon à égaliser les signaux de sortie, les deux facteurs d'amplification étant alors dans le même rapport N.

Par ailleurs, selon un mode de mise en oeuvre, on contrôle à la valeur N le rapport entre les facteurs d'amplification respectifs de deux amplificateurs linéaires auxiliaires à facteur d'amplification commandable par un signal de commande auxiliaire, et ayant respectivement les même structures que celle des amplificateurs principaux, en générant lesdits signaux de commande auxiliaires à partir des signaux de commande principaux respectivement associés aux amplificateurs principaux de structures correspondantes.

D'autres avantages et caractéristiques de l'invention apparaîtront à l'un examen détaillé de modes de réalisation nullement limitatifs et de dessins annexés sur lesquels :

- la figure 1 décrit schématiquement un mode de réalisation d'un circuit principal selon l'invention,
- la figure 2 décrit plus .précisément un mode de réalisation d'un circuit principal selon l'invention,
- la figure 3 décrit plus particulièrement un exemple d'une partie d'un amplificateur linéaire incorporé dans un dispositif, selon l'invention,
- la figure 4 illustre un dispositif électronique selon l'invention incorporant deux modes de réalisation de circuits auxiliaires selon l'invention,
- la figure 5 illustre un autre mode de réalisation d'un dispositif selon l'invention incorporant deux modes de réalisation de circuits auxiliaires selon l'invention,
- la figure 6 représente un mode de réalisation d'une partie d'un circuit auxiliaire selon l'invention, et
- la figure 7 illustre un mode de réalisation d'un autre circuit auxiliaire selon l'invention, utilisé dans le mode de réalisation du dispositif présenté sur la figure 5.

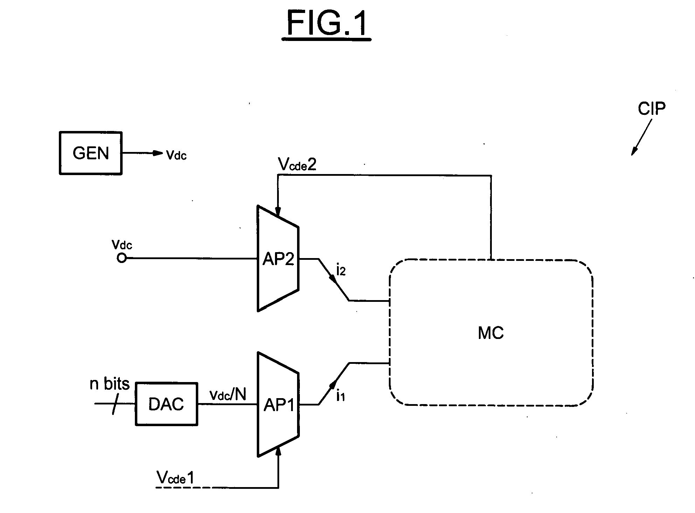

Sur la figure 1, la référence CIP représente un circuit principal, dont des exemples d'utilisation seront explicités ci-après.

Le circuit principal CIP comprend un premier amplificateur linéaire principal AP1 commandé par un signal de commande principal Vcde1, ici une tension de commande.

Le signal de commande Vcde1 est a priori arbitraire, mais doit appartenir au domaine de fonctionnement de l'amplificateur principal AP1.

Le circuit principal CIP comprend également un deuxième amplificateur linéaire principal AP2 commandé par un deuxième signal de commande principal Vcde2, ici une tension.

Le deuxième amplificateur principal AP2 reçoit en entrée un signal de référence, ici une tension vdc délivrée par un générateur GEN.

Cette tension vdc possède une valeur arbitraire appartenant au domaine de fonctionnement des amplificateurs principaux AP1 et AP2 et est de la forme dite « petit signal », c'est-à-dire qu'elle est formée par une valeur statique et éventuellement d'une petite variation dynamique autour de cette valeur statique.

La tension vdc est délivrée à un diviseur DAC programmable à l'aide de n bits. Le diviseur DAC délivre alors une tension de sortie égale à vdc/N, N étant le rapport de division du diviseur DAC.

Le rapport de division N est un réel.

En variant, il est possible d'utiliser un multiplieur par N.

Le premier amplificateur principal AP1 reçoit en entrée la tension divisée vdc/N et délivre en sortie un courant il.

Le deuxième amplificateur principal AP2 délivre quant à lui un courant i2.

Dans le cas d'amplificateurs principaux AP1 et AP2, de type à transconductance (ce qui est le cas pour tous les amplificateurs cités en exemple ci-après), ayant respectivement une transconductance gm1 et gm2, on a la relation : i2= gm2.vdc, et

il= gm1.vdc/N.

Par conséquent, en égalisant les courants i1 et i2 on obtient :

gm2 = gm1/N.

Ainsi, pour obtenir le rapport N entre les deux transconductances des deux amplificateurs principaux AP1 et AP2, il suffit d'égaliser les deux courants i1 et i2.

Pour ce faire, les deux courants i1 et i2 sont délivrés à des moyens de contrôle MC.

Les moyens de contrôle MC délivrent en sortie la tension de commande Vcde2 qui est fonction de l'écart existant entre les courants de sortie il et i2, de façon à modifier gm2 et par conséquent i2, pour qu'il soit égal à i 1.

De cette façon, les deux amplificateurs principaux AP1 et AP2 ont bien deux transconductances dans le rapport N.

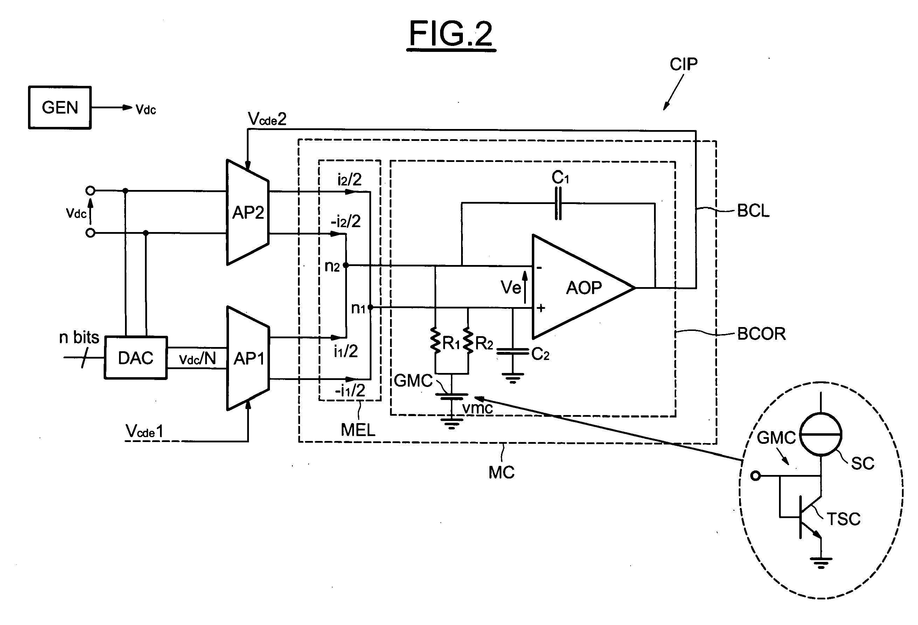

On se réfère à présent à la figure 2 qui détaille un mode de réalisation des moyens de contrôle du circuit principal CIP.

On considère pour ce mode de réalisation, que le circuit CIP possède une architecture différentielle.

Les moyens de correction MC forment ici des moyens d'asservissement du signal de commande Vcde2. Ils comprennent des moyens d'élaboration MEL qui correspondent dans cet exemple à des moyens d'addition. Ils comportent un premier noeud n 1 entre la deuxième sortie de l'amplificateur principal AP2 et la première sortie de l'amplificateur principal AP1, de façon à élaborer un signal, ici un courant, égal à $\dfrac{(i1 - i2)}{2}$ .

Les moyens d'élaboration MEL comprennent en outre un deuxième noeud n2 connectant la première sortie de l'amplificateur principal AP2 et la deuxième sortie de l'amplificateur principal AP1 de façon à élaborer un courant égal à $\dfrac{(i2 - i1)}{2}$ .

Dans le cas d'un rapport N négatif, l'homme du métier saura adapter les moyens d'élaboration MEL en réalisant des moyens de soustraction au lieu de moyens d'addition.

De même l'homme du métier saura adapter les moyens d'élaboration MEL dans le cas ou les grandeurs des signaux de sortie des amplificateurs principaux sont des tensions.

Les deux courants élaborés par les moyens d'élaboration MEL sont délivrés à un bloc de correction BCOR, apte à effectuer dans cet exemple une correction de type proportionnelle intégrale.

Un amplificateur opérationnel AOP reçoit sur ses entrées les deux courants élaborés par les moyens d'élaboration MEL.

Le bloc de correction BCOR comprend également deux résistances R1 et R2 ici de même valeur R et connectées respectivement entre chaque entrée de l'amplificateur opérationnel AOP et un générateur de tension de mode commun GMC délivrant une tension vmc et reliée à la masse.

La tension différentielle aux bornes de l'AOP est donc égale à R(i2-i1).

Le générateur GMC peut être réalisé par exemple à l'aide d'une source de courant SC connectée à un transistor TSC dont l'électrode de commande est rebouclée sur l'électrode connectée à la source SC, la dernière électrode étant reliée à la masse.

La correction intégrale est réalisée à l'aide de deux condensateurs C1 et C2 ici de même valeur et respectivement connectés entre l'entrée inverseuse et la sortie de l'amplificateur opérationnel AOP et entre l'entrée non inverseuse et la masse de l'amplificateur opérationnel AOP. Cette correction permet de stabiliser le signal délivré en sortie.

Enfin, les moyens de correction comprennent une boucle d'asservissement BCL connectant la sortie de l'amplificateur opérationnel AOP à l'entrée de commande du deuxième amplificateur principal AP2.

Bien entendu, les rôles des amplificateurs AP1 et AP2 peuvent être échangés.

A titre d'exemple, la tension vmc peut être égale à environ 0,8 V, les résistances R1 et R2 peuvent être de l'ordre de 20 kΩ, les condensateurs C1 et C2 de l'ordre de 10pF, et le gain de l'amplificateur opérationnel AOP est de préférence très grand, par exemple égal à environ 50dB.

Les transconductances des amplificateurs linéaires principaux AP1 et AP2 peuvent varier entre 10 et 250 μA/V.

Plus généralement, le bloc de correction BCORR peut effectuer une correction de type proportionnelle-intégrale-dérivée.

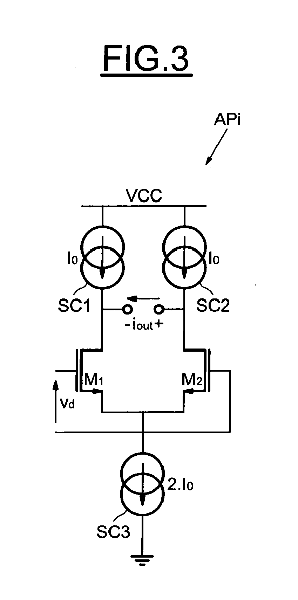

On a représenté sur la figure 3 un exemple d'amplificateur à transconductance commandable utilisé pour réaliser les amplificateurs principaux AP1 et AP2.

L'amplificateur APi reçoit en entrée une tension différentielle vd. Celle-ci est appliquée entre les deux électrodes de commande de deux transistors M1 et M2, ici de type NMOS. Chaque transistor M1 et M2 est polarisé par un courant 10 délivré respectivement par une source de courant commandée SC1 et une autre source de courant commandée SC2. Les deux sources de courant SC1 et SC2 sont reliées à une borne d'alimentation délivrant une tension VCC.

Classiquement, les sources de courant SC1 et SC2 sont réalisées à l'aide de transistors montés en source de courant.

Les deux électrodes d'entrée (ici les sources) des transistors M1 et M2, sont communes, et le noeud commun est connecté à une troisième source de courant SC3 commandable délivrant un courant de 2*10. La source de courant SC3 est par ailleurs reliée par son autre borne à la masse.

Le courant de sortie iout est délivré par l'amplificateur principal APi et mesuré entre deux électrodes de sortie (ici les drains) des transistors M1 et M2.

Ce courant de sortie iout correspond à la différence entre le courant issu du drain de M1 et de M2 et leur courant de polarisation issu respectivement des sources SC1 et SC2.

Pour le cas des amplificateurs ayant une valeur de transconductance opposée, les bornes de l'entrée différentielles ou les bornes de la sortie différentielles sont inversées.

Le circuit principal CIP tel que décrit ci-avant permet notamment d'obtenir deux signaux de commande (ici Vcde1 et Vcde2) pour pouvoir commander deux amplificateurs linéaires auxiliaires de même type et de même structure que les amplificateurs principaux.

Dans le cas d'amplificateurs auxiliaires à transconductance commandable, les signaux de commande (principaux dans le cas du circuit CIP) s'appliquent sur les bornes de commandes des sources SC1 et SC2, et plus précisément sur les électrodes de commande des transistors formant ces sources.

L'homme du métier saura adapter l'application des signaux de commande dans le cas des amplificateurs à transimpédance ou à gain tension/tension ou courant/courant.

On entend par même structure de deux amplificateurs linéaires, le fait qu'ils soient identiques ou homothétiques, c'est-à-dire qu'il existe un rapport α entre les dimensions des composants de chacun des amplificateurs (par exemple les dimensions W et L des transistors) ainsi qu'entre les sources de polarisation de ces amplificateurs.

Par conséquent, à l'aide des deux signaux de commande principaux, il est possible de commander deux ensembles d'amplificateurs linéaires auxiliaires, chaque ensemble étant de même type et de même structure que l'un des amplificateurs linéaires principaux du circuit CIP, tel que défini ci-dessus.

Etant donné que ces deux ensembles d'amplificateurs linéaires auxiliaires sont de même type, possèdent la même structure que les amplificateurs linéaires principaux, et que leur signaux de commande sont les mêmes, on peut alors établir les mêmes rapports entre le facteur d'amplification des amplificateurs auxiliaires de chaque ensemble, que celui existant entre les amplificateurs linéaires principaux.

Des exemples de dispositifs utilisant les signaux de commande principaux Vcd1 et Vcd2 sont décrits ci-après.

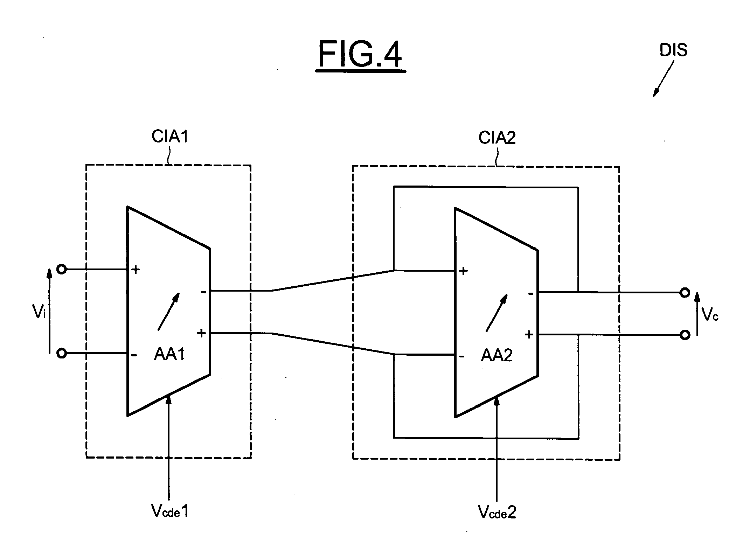

Sur la figure 4, est illustré un dispositif DIS représentant un amplificateur à gain variable (« VGA » en langue anglaise ») ici à architecture différentielle, réalisé à l'aide de deux circuits auxiliaires CIA1 et CIA2.

Le premier circuit auxiliaire CIA1 comprend un amplificateur (ou transconducteur) ayant une transconductance GM1 commandable. Le transconducteur AA1 reçoit sur son entrée différentielle une tension d'entrée Vi, et est commandé par un signal de commande auxiliaire qui correspond à la tension de commande principale Vcde1.

L'amplificateur AA1 est choisi de façon à posséder la même structure que l'amplificateur principal AP1, tel que défini ci-dessus.

Le deuxième circuit auxiliaire CIA2 comprend un deuxième amplificateur auxiliaire AA2 dont l'entrée non inverseuse est reliée à la sortie inverseuse de l'amplificateur auxiliaire AA1, et l'entrée inverseuse est reliée à la sortie non inverseuse de l'amplificateur auxiliaire AA1.

En outre, la sortie non inverseuse de l'amplificateur AA2 est rebouclée sur son entrée non inverseuse et sa sortie non inverseuse est reliée sur son entrée inverseuse.

L'amplificateur auxiliaire AA2 délivre en sortie une tension Vo. En outre, le signal de commande auxiliaire de l'amplificateur auxiliaire AA2 correspond à la tension de commande Vcde2, la structure et le type de l'amplificateur auxiliaire AA2 correspondant à celle de l'amplificateur principal AP2.

L'amplificateur AA2 possède une transconductance GM2 et joue le rôle dans ce dispositif d'une résistance dont la résistivité est égale à 1/GM2, de façon que le gain en tension de l'amplificateur à gain contrôlé soit égal à GM1/GM2.

Du fait que les amplificateurs auxiliaires AA1 et AA2 ont la même structure que les amplificateurs principaux AP1 et AP2 du circuit principal, et qu'ils sont commandés respectivement par les signaux de commande Vcde1 et Vcde2, on a la relation :

$$GM1 = N * GM2.$$

Par conséquent, le gain contrôlé GM1/GM2 est égale à N.

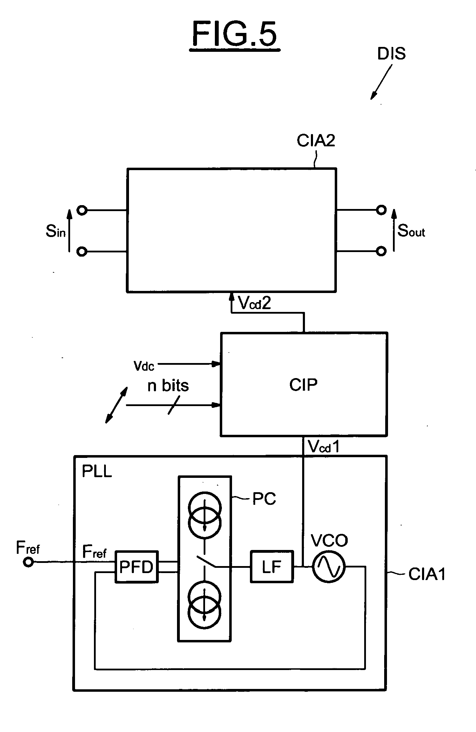

On se rapporte à présent à la figure 5 qui illustre un mode de réalisation du dispositif selon l'invention où les deux circuits auxiliaires CIA1 et CIA2 forment respectivement des moyens maîtres et des moyens esclaves.

Les moyens esclaves CIA2 correspondent ici à un filtre commandé, dont la commande permet de stabiliser la fréquence de coupure à une valeur proportionnelle à une fréquence de référence issue des moyens maîtres CIA1.

Les moyens esclaves CIA2 reçoivent en entrée un signal d'entrée Sin et délivre en sortie un signal de sortie Sout.

Le circuit auxiliaire CIA2 est connecté au circuit principal CIP duquel il reçoit la tension de commande principale Vcde2, en tant que signal de commande auxiliaire.

Le circuit CIA2 comprend ici des moyens de filtrage, par exemple un filtre passe-bas.

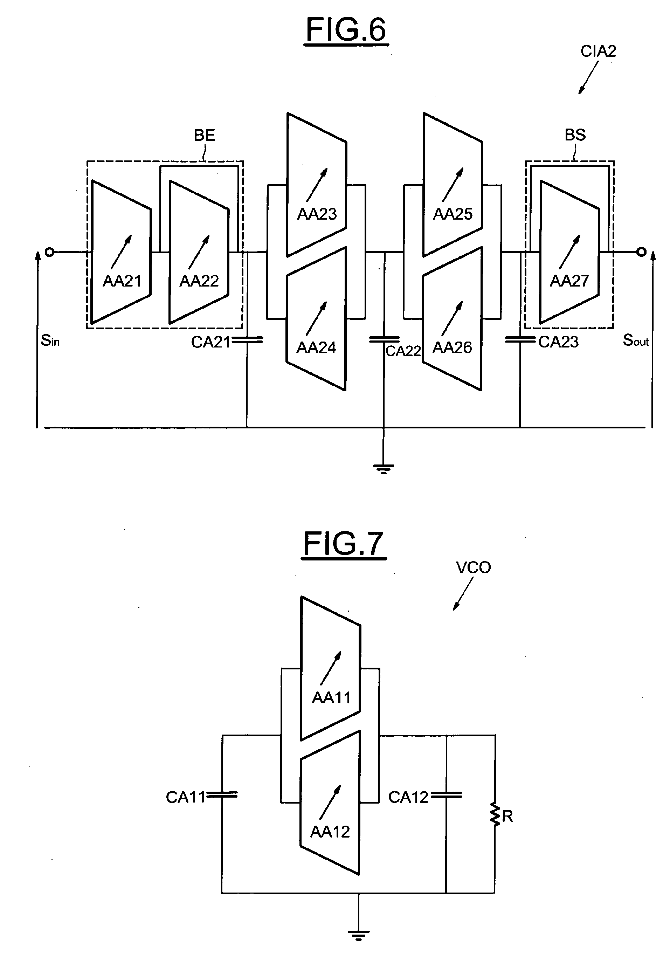

Un exemple de filtre pouvant être incorporé dans le circuit auxiliaire CIA2 est illustré sur la figure 6.

Celui-ci peut comprendre un bloc d'entrée BE formé d'un premier amplificateur linéaire à transconductance commandable auxiliaire AA21 connecté en série à un deuxième amplificateur linéaire commandable AA22 auxiliaire, dont la sortie est rebouclée sur l'entrée.

Il comprend également un bloc de sortie BS comprenant un amplificateur linéaire à transconductance commandable AA27 auxiliaire, dont la sortie est rebouclée sur l'entrée.

Entre le bloc d'entrée BE et le bloc de sortie BS sont connectés en série deux blocs de type gyrateurs, c'est-à-dire formés de deux amplificateurs linéaires à transconductance commandable auxiliaires connectés tête-bêche et ayant des valeurs de transconductance opposées. La première structure comprend les amplificateurs auxiliaires AA23 et AA24 et la deuxième structure comprend les amplificateurs auxiliaires AA25 et AA26.

Un premier condensateur CA21 est connecté entre le noeud commun au bloc d'entrée BE et à l'amplificateur AA23, et la masse.

De même, un deuxième et un troisième condensateur CA22 et CA23 sont respectivement connectés entre le noeud commun aux amplificateurs auxiliaires AA23 et AA25 et la masse, et entre le noeud commun de l'amplificateur auxiliaire AA25 et le bloc de sortie BS et la masse.

Tous les amplificateurs auxiliaires à transconductance commandable du circuit auxiliaire CIA2 sont commandés par un même signal de commande auxiliaire correspondant au signal de commande principal Vcde2. Pour cela, ils ont la même structure et le même type que l'amplificateur principal AP2 du circuit principal CIP.

On se réfère à nouveau à la figure 5. Le circuit auxiliaire CIA1 forment ici les moyens maîtres, dont on utilise la fréquence d'oscillation pour asservir la fréquence de coupure du filtre du circuit auxiliaire CIA2.

Le circuit auxiliaire CIA1 est formé ici d'une boucle à verrouillage de phase PLL réalisée de façon classique.

Celle-ci reçoit en entrée une fréquence de référence Fref délivrée par exemple par un oscillateur à quartz.

La fréquence de référence Fref est délivrée à un discriminateur phase/fréquence PFD connecté à une pompe de charge PC délivrant une tension à un oscillateur contrôlé en tension VCO, par l'intermédiaire d'un filtre LF. Le signal de sortie de l'oscillateur VCO est délivrée en entrée du discriminateur phase/fréquence par l'intermédiaire d'une boucle de rétroaction.

Par ailleurs, la tension de commande de l'oscillateur contrôlé en tension VCO est délivrée au circuit principal CIP, en tant que signal de commande principal Vcd1, de façon à commander le premier amplificateur principal AP1.

On réalise alors l'oscillateur à contrôle en tension à l'aide d'amplificateurs à transconductance commandable comme représenté par exemple sur la figure 7.

Dans cet exemple, l'oscillateur contrôlé en tension VCO comprend une structure de type gyrateur formé à partir de deux amplificateurs à transconductance commandable auxiliaires AA11 et AA12 connectés en série entre deux condensateurs CA11 et CA12. En outre, une résistance R de résistivité négative est connectée parallèlement au condensateur CA12.

Les deux amplificateurs auxiliaires AA11 et AA12 sont commandés par un signal de commande auxiliaire qui est la tension délivrée à l'oscillateur contrôlé en tension VCO, et qui correspond également au signal de commande principal Vcd1.

Les amplificateurs auxiliaires utilisés pour réaliser l'oscillateur contrôlé en tension VCO, sont de même type et de même structure que l'amplificateur principal AP1.

On se réfère à nouveau à la figure 5.

Le circuit principal CIP permet de stabiliser la fréquence de coupure du filtre du circuit auxiliaire CIA2 et également de faire varier cette fréquence de coupure de façon que le filtre du circuit auxiliaire CIA2 puisse fonctionner dans différentes bandes de fréquence.

De par l'utilisation du circuit principal CIP, le signal de commande Vcde2 de la fréquence de coupure du circuit CIA2 n'est plus proportionnelle à la tension de commande Vcd1 de l'oscillateur commandé en tension VCO, et n'est donc plus sensible aux problèmes de linéarités engendrées par l'approximation du rapport de proportionnalité liées à l'utilisation d'un diviseur (ou multiplieur).

L'ordre de dispersion des caractéristiques du filtre peut alors être réduit à un pourcentage d'environ 2%.

Bien entendu, bien que les exemples décrits ci-dessus mettent en oeuvre des amplificateurs linéaires à transconductance, il est également possible d'utiliser des amplificateurs linéaires à transimpédance ou à gain tension/tension ou courant/courant, tous ces amplificateurs ayant un rapport d'amplification commandable par une tension ou un courant selon le mode de réalisation utilisé.

**Revendications**

1. Dispositif électronique, **caractérisé par** fait qu'il comprend un circuit principal comportant :

   deux amplificateurs linéaires principaux (AP1, AP2) ayant des facteurs d'amplification respectivement commandables (gm1, gm2) par deux signaux de commande principaux (Vcde1, Vcde2), aptes à recevoir respectivement deux signaux d'entrée et à délivrer deux signaux de sortie, les niveaux des deux signaux d'entrée étant dans un rapport N, et

   des moyens de contrôle (MC) aptes à ajuster la valeur d'au moins l'un des deux signaux de commande principaux de façon à égaliser les signaux de sortie, les deux facteurs d'amplification étant alors dans le même rapport N.

2. Dispositif selon la revendication 1, dans lequel le circuit comporte en outre un générateur (GEN) apte à générer un signal de référence (vdc), un diviseur (DAC) ou un multiplieur par N couplé à la sortie du générateur et apte à délivrer ledit signal de référence divisé ou multiplié par N, le signal d'entrée de l'un des amplificateurs (AP2) étant le signal de référence (vdc) et le signal d'entrée de l'autre amplificateur (AP1) étant le signal de référence divisé ou multiplié par N (vdc/N).

3. Dispositif selon la revendication 1 ou 2, dans lequel les moyens de contrôle comprennent des moyens d'asservissement aptes à asservir la valeur de l'un des signaux de commande à l'écart entre les deux signaux de sortie.

4. Dispositif selon l'une des revendication 1 à 3, dans lequel les moyens d'asservissement comportent des moyens d'élaboration (MEL) aptes à élaborer un signal intermédiaire représentatif de la différence entre les deux signaux de sortie, et un bloc de correction (BCOR) couplé aux moyens d'élaboration (MEL), apte à effectuer une correction de type proportionnelle-intégrale sur ledit signal intermédiaire.

5. Dispositif selon la revendication 4, dans lequel le bloc de correction (BCOR) est apte à effectuer en outre une correction de type dérivée.

6. Dispositif selon l'une des revendications précédentes, dans lequel le circuit principal présente une architecture différentielle, les signaux d'entrée et de sortie étant des grandeurs différentielles.

7. Dispositif selon les revendications 4 et 6, dans lequel les signaux de sortie délivrés par les amplificateurs principaux (AP1, AP2) sont des courants et dans lequel les moyens d'élaboration (MEL) comprennent des moyens d'addition aptes à additionner d'une part la valeur du courant délivré sur la première voie différentielle d'un premier amplificateur principal et la valeur du courant délivré sur la deuxième voie différentielle de l'autre amplificateur principal et d'autre part la valeur du courant délivré sur la deuxième voie différentielle dudit premier amplificateur principal et la valeur du courant délivré sur la première voie différentielle de l'autre amplificateur principal.

8. Dispositif selon la revendication 7, dans lequel le bloc de correction (BCOR) comprend un amplificateur opérationnel (AOP), deux résistances (R1, R2), connectées entre chacune des entrées de l'amplificateur opérationnel (AOP) et un générateur de tension de mode commun (GMC), un premier condensateur (C2) connecté entre l'entrée non-inverseuse de l'amplificateur opérationnel et la masse et un deuxième condensateur (C1) de même valeur que ledit premier condensateur, connecté entre la sortie et l'entrée inverseuse de l'amplificateur opérationnel (AOP).

9. Dispositif selon l'une des revendications précédentes, comprenant en outre au moins deux circuits auxiliaires (CIA1, CIA2) comportant chacun au moins un amplificateur linéaire auxiliaire à facteur d'amplification commandable par un signal de commande auxiliaire, les amplificateurs auxiliaires (AAi) des deux circuits auxiliaires (CIA1, CIA2) ayant respectivement les mêmes structures que celles des deux amplificateurs principaux, et
dans lequel les signaux de commande auxiliaires respectivement associés aux deux circuits auxiliaires sont respectivement issus des signaux de commande principaux respectivement associés aux amplificateurs principaux de structures correspondantes.

10. Dispositif selon la revendication 9, dans lequel le premier et le deuxième circuit auxiliaires comprennent respectivement un premier (AA1) et un deuxième amplificateurs (AA2) linéaires auxiliaires connectés en série, la sortie du deuxième amplificateur linéaire auxiliaire étant rebouclé sur son entrée.

11. Dispositif selon la revendication 9, dans lequel
un premier circuit auxiliaire forme des moyens esclaves, qui comportent des moyens de filtrage incorporant au moins un amplificateurs linéaires auxiliaires, et dans lequel
un deuxième circuit auxiliaire forme des moyens maîtres, aptes à asservir la fréquence de coupure des moyens de filtrage, et qui comportent une boucle à verrouillage de phase (PLL) comprenant un oscillateur contrôlé en tension (VCO) réalisé à l'aide d'au moins deux amplificateurs linéaires commandés par le signal de commande auxiliaire associé audit deuxième circuit auxiliaire,
le signal de commande auxiliaire associé audit deuxième circuit auxiliaire étant délivré au circuit principal de façon à réaliser le signal de commande de l'amplificateur principal recevant le signal de référence divisé ou multiplié par N.

12. Procédé de contrôle du rapport de facteurs d'amplification d'amplificateurs linéaires commandables, comprenant un ajustement à une valeur N désirée, du rapport entre les facteurs d'amplification respectifs de deux amplificateurs linéaires principaux (AP1, AP2) commandables par deux signaux de commandes principaux (Vcse1, Vcde2), ledit ajustement comprenant
la réception de deux signaux d'entrée et la délivrance de deux signaux de sortie par les amplificateurs principaux, les niveaux des deux signaux d'entrée étant dans un rapport N, et
le contrôle de l'un des deux signaux de commande principaux de façon à égaliser les signaux de sortie, les deux facteurs d'amplification étant alors dans le même rapport N.

13. Procédé selon la revendication 12, pour le contrôle à la valeur N du rapport entre les facteurs d'amplification respectifs de deux amplificateurs linéaires auxiliaires à facteur d'amplification commandable par un signal de commande auxiliaire, et ayant respectivement les même structures que celle des amplificateurs principaux, et dans lequel on génère lesdits signaux de commande auxiliaires à partir des signaux de commande principaux respectivement associés aux amplificateurs principaux de structures correspondantes

EP 1 804 379 A1

# FIG.1

# FIG.2

EP 1 804 379 A1

# FIG.3

## FIG.4

DIS

CIA2

AA2

$V_c$

$V_{cde}2$

CIA1

AA1

$V_i$

$V_{cde}1$

# FIG.5

DIS

## FIG.6

## FIG.7

**Office européen
des brevets**

**RAPPORT DE RECHERCHE EUROPEENNE**

Numéro de la demande

EP 06 29 2023

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2005/242871 A1 (WANG ZHENHUA) 3 novembre 2005 (2005-11-03) * alinéas [0052], [0053]; figure 3 * ----- | 1-13 | INV. H03H11/04 H03H11/12 H03F3/19 |
| A | US 2001/048342 A1 (YOSHIDA YOSHIKAZU ET AL) 6 décembre 2001 (2001-12-06) * alinéas [0156] - [0167]; figure 12 * ----- | 1-13 | H03F3/21 H03F3/60 H03F1/32 |
| A | US 5 663 682 A (MELINE ET AL) 2 septembre 1997 (1997-09-02) * colonne 2, ligne 53 - colonne 3, ligne 45; figure 3 * ----- | 1-13 | |

| | |
|---|---|
| | **DOMAINES TECHNIQUES RECHERCHES (IPC)** |
| | H03F H03H |

Le présent rapport a été établi pour toutes les revendications

| Lieu de la recherche | Date d'achèvement de la recherche | Examinateur |
|---|---|---|
| La Haye | 7 mai 2007 | Fedi, Giulio |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 06 29 2023

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-05-2007

| Document brevet cité au rapport de recherche | | Date de publication | Membre(s) de la famille de brevet(s) | | Date de publication |
|---|---|---|---|---|---|
| US 2005242871 | A1 | 03-11-2005 | AU<br>CN<br>WO<br>JP | 2003255998 A1<br>1679234 A<br>2004023653 A1<br>2005538597 T | 29-03-2004<br>05-10-2005<br>18-03-2004<br>15-12-2005 |
| US 2001048342 | A1 | 06-12-2001 | JP | 2001332959 A | 30-11-2001 |
| US 5663682 | A | 02-09-1997 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **YANNIS TSIVIDIS.** Integrated Continuous-Time Filter Design - An Overview. *IEEE Journal of Solid-State Circuits,* Mars 1997, vol. 29 (3), 166-176